# FASCICULE DE BREVET EUROPEEN

(11) **EP 1 094 528 B1**
(45) Date de publication et mention de la délivrance du brevet: **01.02.2017**
(21) Numéro de dépôt: 00402881.7
(22) Date de dépôt: 18.10.2000
(51) Int. Cl.: H01L 31/048

(54) **Module solaire à colmatage de bordure**
Solarmodul mit aufgefüllten Rändern
Solar module with filled up edges

(30) Priorité: 22.10.1999 DE 19950893
(43) Date de publication de la demande: 25.04.2001
(73) Titulaire: SAINT-GOBAIN GLASS FRANCE, 92400 Courbevoie (FR)
(72) Inventeur: Blieske, Ulf, 41061 Mönchengladbach (DE); Janke, Nikolas, 52134 Herzogenrath (DE); Hauser, Hubert, 52146 Würselen (DE)
(74) Mandataire: Gebauer, Dieter Edmund

(56) Documents cités:
- US-A- 5 460 660
- US-A- 5 667 595
- PATENT ABSTRACTS OF JAPAN vol. 2000, no. 19, 5 juin 2001 (2001-06-05) -& JP 2001 053320 A (MATSUSHITA BATTERY INDUSTRIAL CO LTD), 23 février 2001 (2001-02-23)

## Description

L'invention se rapporte à un module solaire à colmatage de bordure ayant les caractéristiques du préambule de la revendication 1.

On connaît, à partir du document DE 195 14 908 C1, un procédé de fabrication d'un module solaire, lors duquel on utilise un polyuréthanne-polyéther en tant que masse de coulée en vue du colmatage des cellules solaires en couches minces noyées entre deux vitres en verre.

Après la fixation des cellules solaires sur une plaque de support, on fabrique les connections électriques entre les cellules solaires individuelles (circuit en série) et on achemine vers l'extérieur les conduites en lignes groupées à des endroits prédéterminés par-dessus le bord de la plaque en verre de support. On dépose alors, le long du bord de la vitre, un boyau adhésif, par exemple par extrusion, qui sert, d'une part, à l'étanchéification de bordure du module solaire et, qui agit, d'autre part, en tant qu'entretoise d'écartement entre les deux vitres en verre. Rien n'est mentionné quant à la composition du boyau adhésif, à l'exception de sa capacité d'extrusion, rien non plus n'étant dit par ailleurs quant au type de construction des cellules solaires.

Dans deux zones de coin diagonalement opposées du boyau adhésif, on introduit des tronçons de tube, qui servent au remplissage et à la ventilation subséquents de l'espace creux entre les deux vitres en verre. On applique alors la vitre en verre avant. Les deux vitres en verre sont alors comprimées l'une sur l'autre jusqu'à parvenir à l'écartement souhaité.

On remplit ensuite le mélange de résine de coulée dans l'espace creux entre les deux vitres en verre, le module solaire étant de préférence orienté dans une position à peu près verticale et la masse de résine de coulée étant remplie par l'intermédiaire du tube inférieur, alors que le tube supérieur sert à la ventilation. Après le remplissage, les deux tubes sont retirés et les orifices sont étanchéifiés à l'aide d'une masse adhésive.

Le module solaire rempli ainsi sans formation de bulles est maintenant placé dans un autoclave. La température de l'autoclave est à peu près de 40°C, et la surpression dans l'autoclave est réglée à peu près à 0,6 bar. Dans ces conditions, la résine de coulée se polymérise et parvient, après 60 minutes, à l'état complètement durci. Après le retrait de l'autoclave, le module solaire est prêt à l'emploi. Dans la pratique de fabrication de ce module solaire, on peut également se passer de surpression.

Un mode de construction répandu de cellules solaires est réalisé avec une couche d'agent absorbant contenant du cuivre, de l'indium et du sélénium, quelquefois également du soufre à la place du sélénium, en tant que constituants (il s'agit là de ce que l'on appelle des couches d'agent absorbant CIS). On peut aussi ajouter à la couche d'agent absorbant du gallium (couches d'agent absorbant CIGS). On les désigne en général et ci-après par le terme de couches d'agent absorbant à chalcopyrite. On sait que leur rendement photovoltaïque est réduit de manière notable lors de la pénétration d'humidité, respectivement lors de la pénétration par diffusion de molécules d'eau, même sans une détérioration visible de l'aspect optique.

Dans le cas des modules solaires énumérés, du type cité au début, à couche d'agent absorbant à chalcopyrite, on utilise une bande d'acrylate en tant que joint d'étanchéité de bordure (disponible dans le commerce sous la désignation de 3M Isotac 4918). Il s'est avéré que les cellules solaires pourvues de ce joint d'étanchéité, après passage de l'essai Damp-Heat conformément à la norme IEC 61215 (IEC=International Energy Commission), étaient certes impeccables du point de vue optique, mais que leur rendement avait chuté de plus de 20% à la suite des molécules d'eau introduites par diffusion dans la couche d'agent absorbant à chalcopyrite. Selon la norme IEC 1646, n'est permise cependant qu'une diminution de 5%.

L'essai Damp-Heat cité se compose pour l'essentiel d'un stockage des modules solaires pendant plus de 1000 heures à une température de 85°C et à une humidité relative de 85%. Il s'est avéré que la pénétration par diffusion des molécules d'eau augmente rapidement avec la durée d'utilisation.

On sait, dans ce contexte (document DE 197 33 913 A1), en vue de la fabrication d'un capsulage, résistant au climat, d'éléments de construction à couches minces, par exemple des modules solaires à couche d'agent absorbant à chalcopyrite, procéder au remplissage d'un espace creux formé entre un cadre et la bordure de l'élément de construction à l'aide d'un agent de séchage en vue de l'adsorption de l'humidité. Il s'agit d'éviter de ce fait une turbidité conditionnée par l'humidité de l'adhésif stratifié utilisé ainsi que la corrosion des bandes de soudure conduisant le courant en vue de la mise en contact électrique externe des modules.

Conformément au document DE 195 03 510 C2, on peut sceller en bordure des vitres en verre composites, qui sont pourvues d'un revêtement, réfléchissant la chaleur, qui est noyé dans le composite, en ne prolongeant pas le revêtement jusqu'au bord externe et en scellant la fente périphérique en bordure entre les deux vitres en verre à l'aide d'un polymère introduit par pulvérisation, lequel polymère peut être combiné par fusion avec le polymère constituant le composite.

On sait aussi (document DE 41 31 393 C2) munir les faces internes des vitres individuelles d'une vitre d'isolation en verre classique de cellules solaires, dont les connexions électriques sont acheminées au-delà du composite de bordure hors de l'espace interne scellé de manière étanche aux gaz. Le composite de bordure se compose là d'une entretoise d'écartement, de son collage aux vitres en verre et d'un colmatage d'un genre classique disposé à l'extérieur. Dans cette publication, on décrit également les cellules solaires noyées dans la résine de coulée, qui sont protégées également par un joint d'étanchéité de bordure contre les influences de l'extérieur. La composition de ce joint d'étanchéité n'est cependant pas spécifiée de plus près.

Pour le colmatage des espaces intermédiaires en forme de disques des vitres d'isolation en verre, on sait introduire un agent de séchage en tant qu'agent absorbant de l'humidité dans l'entretoise d'écartement, qui peut être fabriquée à partir d'un profilé métallique collé ou d'un boyau d'élastomère. L'agent de séchage est également désigné en tant que tamis moléculaire.

Le document US5460660 décrit un module solaire dont l'entretoise d'écartement est un profilé en acier comprenant un agent absorbant l'humidité.

Si l'entretoise d'écartement n'est faite qu'à partir d'un élastomère (en anglais "thermostatic spacer", en bref TPS), on mélange l'agent de séchage à la masse de matière synthétique avant l'application (par exemple avant l'extrusion) sur le bord de la vitre en verre. Un mélange commercial (le produit Naftotherm® BU-TPS de la société Chemetall GmbH) pour une entretoise d'écartement thermoplastique se compose de polyisobutylène en tant que base et de poudre de zéolite en tant qu'agent de séchage. Ce matériau à un composant, exempt de solvants, est capable d'extrusion dans le domaine d'environ 140-160°C et adhère bien au verre.

L'objet fondamental de l'invention est d'indiquer un joint d'étanchéité encore amélioré d'un élément de construction à couches minces avec une couche d'agent absorbant à chalcopyrite.

Cet objet est résolu selon l'invention à l'aide des caractéristiques de la revendication 1. Les caractéristiques des revendications secondaires indiquent des perfectionnements avantageux de cet article.

On combine ainsi, en partant d'un module solaire conformément au document DE 195 14 908 C1, tout d'abord l'entretoise d'écartement avec un tamis moléculaire, de manière à fixer ainsi toute humidité qui pourrait pénétrer dans la zone en bordure. La fente de bordure est remplie à son tour, sur tout le pourtour, d'un adhésif, par exemple d'un polysulfure, qui constitue une barrière supplémentaire contre l'humidité. L'entretoise d'écartement thermoplastique est en outre soulagée du point de vue mécanique par cet adhésif supplémentaire, de sorte que le module est également plus résistant du point de vue mécanique.

Il peut être avantageux d'appliquer, en bordure, un promoteur d'adhésion sur les surfaces des plaques, qui enclosent le module solaire, afin d'améliorer l'adhésion entre l'entretoise d'écartement polymère et l'adhésif, d'une part, et le verre, d'autre part.

Une protection efficace contre le vieillissement et la tendance à la fragilisation du collage ou du colmatage en bordure des modules solaires à la suite de l'action de la partie UV de la lumière solaire peut être fournie par une couche de couleur opaque, qui est appliquée en bordure tout au moins sur la plaque tournée, au stade de la construction, vers le rayonnement solaire. Des couches de couleur en bordure de ce genre, qui peuvent être fabriquées, par exemple par sérigraphie et cuisson subséquente, sont usuelles en général dans le cas de vitrages de véhicules automobiles.

Quand des connexions électriques doivent être acheminées vers l'extérieur par-dessus le bord de l'une des plaques, elles sont formées ainsi, conformément à une exécution appropriée, tout au moins dans la zone du colmatage en bordure, par des bandes en cuivre, qui sont liées par un contact matériel sous forme de nappe, d'une part, avec la plaque, par exemple par collage ou soudage avec une brasure appropriée à la liaison de métal au verre, et qui sont recouvertes, d'autre part, par le colmatage en bordure. De cette manière, on ne perturbe que de façon minimale, aux conduites de traversée correspondantes, la fabrication du colmatage en bordure par extrusion tout en réalisant, malgré tout, une bonne étanchéification de ces endroits.

Une fabrication particulièrement simple du colmatage en bordure par extrusion s'obtient toutefois quand les connexions électriques des cellules solaires sont acheminées vers l'extérieur non pas par-dessus le bord d'une des plaques, mais à travers un percement dans une surface de plaque et quand elles ne doivent, par conséquent, pas être prises en compte spécialement lors de l'extrusion du colmatage en bordure. Ce percement peut être obturé, après le passage des connexions, de manière fiable, à l'aide d'une masse d'étanchéité appropriée.

Dans un exemple de réalisation préféré d'un module solaire selon l'invention, on réalise les cellules solaires à couches minces d'une manière connue en soi directement sur une des plaques (en verre) du module. On applique tout d'abord une électrode de base métallique, par exemple en molybdène (Mo). On fabrique ensuite une couche d'agent absorbant à chalcopyrite sur l'électrode de base. On applique finalement une électrode frontale transparente, par exemple en oxyde de zinc (ZnO), sur la couche d'agent absorbant. L'électrode de base et l'électrode frontale peuvent être déposées de préférence par pulvérisation cathodique à assistance par champ magnétique. Il faut prévoir, le cas échéant, d'une manière connue entre la couche d'agent absorbant à chalcopyrite et l'électrode frontale, une couche tampon.

D'une manière connue, on fabrique, par subdivision ("structuration") de la couche multiple sur toute sa superficie et des connexions conductrices appropriées, une multiplicité de cellules solaires branchées en série du point de vue électrique. Les deux connexions électriques externes sont disposées vers l'extérieur par-dessus le bord des plaques ; elles sont exécutées, tout au moins dans la zone du colmatage en bordure encore à réaliser, de préférence sous forme de bandes de cuivre plates, qui sont liées à la plaque sous-jacente sous forme de nappe par collage ou soudage. Une section transversale à conductivité relativement grande est nécessaire pour pouvoir décharger de manière sûre la puissance électrique complète des cellules solaires. C'est pourquoi des conduites réalisées grâce à l'impression par sérigraphie de pâtes conductrices n'entrent pas en ligne de compte pour cette application.

Dans une variante, on achemine vers l'extérieur les connexions électriques externes du module solaire par un trou dans la surface des plaques. On évite ainsi toute perturbation du colmatage en bordure provoquée par le passage des conduites.

On applique maintenant, par analogie à la manière de procéder divulguée au début dans le document DE 195 14 908 C1, le long du bord de la plaque, toutefois avec un décalage réduit vers l'intérieur, une entretoise d'écartement faite d'un matériau thermoplastique mélangé à un agent de séchage, de préférence fait du produit déjà cité. On dispose par-dessus la deuxième plaque transparente du module, et on comprime les deux plaques à la distance d'écart souhaitée. On remplit maintenant, dans la fente en bordure restante, le boyau adhésif fournissant vers l'extérieur une action d'étanchéification supplémentaire.

Grâce à des outils appropriés, on peut cependant produire par co-extrusion l'entretoise d'écartement et le boyau d'adhésif d'une manière différant de la méthode suscitée, c'est-à-dire qu'en une étape de travail, on dépose les deux boyaux l'un à côté de l'autre sur la plaque pourvue de cellules solaires, avant l'application de la deuxième plaque.

Il est bien entendu que sont à prévoir au moins un orifice d'introduction de la masse de coulée transparente qui est encore à remplir ainsi qu'au moins un orifice de ventilation.

Après le remplissage de la masse de remplissage transparente, il faut obturer de manière étanche les orifices de remplissage et de ventilation. Le durcissement ou la réaction de solidification de la masse de remplissage peut se dérouler, le cas échéant, d'une manière également connue dans un autoclave sous l'action de la chaleur et, en cas de besoin, par application de pression.

Après ce traitement, le module solaire est prêt à l'emploi. Grâce à la masse de remplissage durcie, les deux plaques sont très solidement liées l'une à l'autre sous forme de nappe, d'une manière similaire à une vitre en verre composite ; le colmatage en bordure double selon l'invention garantit en outre que, même en cas d'une utilisation prolongée de modules solaires de ce genre à l'extérieur, dans des conditions climatiques changeantes, il n'y a lieu de s'attendre à aucune panne quelconque à la suite de la pénétration de l'humidité.

## Revendications

1. Module solaire à cellules solaires en couches minces avec une couche d'agent absorbant à chalcopyrite, disposées entre deux plaques, en particulier entre des plaques en verre, et scellées à l'aide d'une masse de coulée, un colmatage de bordure étant disposé le long du bord des plaques dans une fente en bordure entre les deux plaques et des connexions électriques des cellules solaires étant acheminées vers l'extérieur hors de l'espace enclos, **caractérisé en ce que** le colmatage de bordure comprend une entretoise d'écartement et un boyau adhésif, l'entretoise d'écartement se composant d'un élastomère thermoplastique mélangée à un milieu absorbant l'humidité et étant disposé le long du bord des plaques dans la fente en bordure avec un décalage réduit ver l'intérieur, le boyau adhésif remplissant la fente en bordure restante.

2. Module solaire selon la revendication 1, **caractérisé en ce que** les plaques sont revêtues, dans le domaine de contact en bordure avec l'entretoise d'écartement et le boyau adhésif, d'un promoteur d'adhésion.

3. Module solaire selon l'une quelconque des revendications précédentes, **caractérisé en ce que** les connexions électriques sont formées, au moins dans le domaine du colmatage de bordure, par des bandes en cuivre, qui sont reliées d'une part avec la plaque par l'intermédiaire d'un contact matériel sous forme de nappe en particulier par collage, et qui sont recouvertes d'autre part du colmatage de bordure.

4. Module solaire selon l'une quelconque des revendications précédentes, **caractérisé en ce que** les connexions électriques sont acheminées dans une des plaques par un évidement, qui est obture d'une manière étanche a l'humidité par une masse d'étanchéité.

5. Module solaire selon l'une quelconque des revendications précédentes, **caractérisé en ce que** l'entretoise d'écartement et le boyau adhésif étant déposés l'un a côté de l'autre par co-extrusion.

## Patentansprüche

1. Dünnschicht-Solarzellenmodul mit einer Chalkopyrit-Absorberschicht, welche zwischen zwei Platten, insbesondere zwischen Glasplatten, angeordnet und mit einer Gießmasse versiegelt sind, wobei eine Randabdichtung entlang dem Rand der Platten in einem Randspalt zwischen den beiden Platten angeordnet ist und elektrische Anschlüsse der Solarzellen aus dem umschlossenen Raum nach außen geführt sind, **dadurch gekennzeichnet, dass** die Randabdichtung einen Abstandhalter und einen Klebestrang umfasst, wobei sich der Abstandhalter aus einem mit einem feuchtigkeitsabsorbierenden Mittel durchmischten thermoplastischen Elastomer zusammensetzt und entlang dem Rand der Platten in dem Randspalt, mit geringem Versatz nach innen angeordnet ist, und wobei der Klebestrang den verbleibenden Randspalt ausfüllt.

2. Solarmodul nach Anspruch 1, **dadurch gekennzeichnet, dass** die Platten im Randkontaktbereich mit dem Abstandhalter und dem Klebestrang mit einem Haftvermittler beschichtet sind.

3. Solarmodul nach einem der vorstehenden Ansprüche, **dadurch gekennzeichnet, dass** die elektrischen Anschlüsse zumindest im Bereich der Randabdichtung durch Kupferbänder gebildet sind, welche einerseits mit der Platte durch Materialkontakt flächig verbunden sind, insbesondere durch Kleben, und andererseits von der Randabdichtung bedeckt sind.

4. Solarmodul nach einem der vorstehenden Ansprüche, **dadurch gekennzeichnet, dass** die elektrischen Anschlüsse durch eine Aussparung in einer der Platten geführt sind, welche mit einer Dichtmasse feuchtigkeitsdicht verschlossen ist.

5. Solarmodul nach einem der vorstehenden Ansprüche, **dadurch gekennzeichnet, dass** der Abstandhalter und der Klebestrang durch Koextrusion nebeneinander angeordnet sind.

## Claims

1. Solar module based on thin-film solar cells with a chalcopyrite absorbent layer which are placed between two plates, particularly between glass plates, and are sealed by means of a casting substance, wherein a border seal being deposited along the edge of the plates in the border slot between the two plates and electrical connections of the solar cells being taken to the outside of the enclosed space, **characterized in that** the border seal comprises a spacer and an adhesive bead, wherein the spacer is composed of a thermoplastic elastomer mixed with a moisture absorbing medium and is applied along the edge of the plates but with a small offset towards the inside, and wherein the remaining border slot is filled with the adhesive bead.

2. Solar module according to claim 1, **characterized in that** the plates are coated, in the border region of contact with the spacer and the adhesive bead, with an adhesion promoter.

3. Solar module according to any one of the preceding claims, **characterized in that** the electrical connections are formed, at least in the border sealing region, by copper strips which are connected, on the one hand, to the plate with positive locking, particularly by adhesive bonding, and which are covered, on the one hand, with the border seal.

4. Solar module according to any one of the preceding claims, **characterized in that** the electrical connections are taken into one of the plates via a recess which is sealed in a moisture-tight manner by a sealant.

5. Solar module according to any one of the preceding claims, **characterized in that** the spacer and the adhesive bead are deposited one beside the other by co-extrusion.
